# FASCICULE DE BREVET EUROPEEN

(11) **EP 3 900 018 B1**
(45) Date de publication et mention de la délivrance du brevet: **20.11.2024**
(21) Numéro de dépôt: 19848875.1
(22) Date de dépôt: 18.12.2019
(51) Int. Cl.: H01L 21/02, H01L 21/28, H01L 29/78, H01L 33/38, H01L 29/20, H01L 21/285, H01L 29/66, H01L 33/40

(54) **PROCEDE DE FABRICATION D'UN COMPOSANT SEMICONDUCTEUR A BASE D'UN COMPOSE III-N**
VERFAHREN ZUR HERSTELLUNG EINES HALBLEITERBAUELEMENTS AUF DER BASIS EINER III-N-VERBINDUNG
PROCESS FOR PRODUCING A SEMICONDUCTOR COMPONENT BASED ON A III-N COMPOUND

(30) Priorité: 20.12.2018 FR 1873668
(43) Date de publication de la demande: 27.10.2021
(73) Titulaire: Commissariat à l'Energie Atomique et aux Energies Alternatives, 75015 Paris (FR)
(72) Inventeur: ROTTNER, Jean, 38054 GRENOBLE CEDEX 9 (FR); HAAS, Helge, 38054 GRENOBLE CEDEX 9 (FR)
(74) Mandataire: Cabinet Beaumont
(86) Numéro de dépôt international: PCT/FR2019/053174
(87) Numéro de publication internationale: WO 2020/128339

(56) Documents cités:
- EP-A2- 2 642 533
- US-A1- 2013 161 705
- US-A1- 2016 322 538

## Description

La présente demande de brevet revendique la priorité de la demande de brevet français FR18/73668.

### Domaine technique

La présente description concerne de façon générale le domaine des composants semiconducteurs, et vise plus particulièrement un procédé de fabrication d'un composant semiconducteur à base d'un composé III-N, ainsi qu'un composant réalisé par ce procédé.

### Technique antérieure

On a déjà proposé de nombreuses structures de composants semiconducteurs à base d'un ou plusieurs composés III-N, par exemple des diodes électroluminescentes, des diodes photosensibles, des diodes de puissance, des transistors de puissance, etc.

La fabrication de tels composants pose toutefois des difficultés, notamment liées à la gravure des composés III-N et à la formation de métallisations de connexion en contact avec les composés III-N.

Le document US 2016/322538 A1 divulgue un procédé qui utilise un espaceur métallique pour graver une tranchée dans un semi-conducteur III-V. 1

### Résumé de l'invention

L'invention prévoit un procédé de fabrication d'un composant semiconducteur, comprenant les étapes successives suivantes :
a) former un empilement comportant une première couche semiconductrice en un composé III-N, une deuxième couche conductrice revêtant la première couche, et une troisième couche de masque dur revêtant la deuxième couche ;
b) former une tranchée traversant les troisième et deuxième couches et s'interrompant sur la première couche, ladite tranchée délimitant latéralement une métallisation de contact dans la deuxième couche ;
c) former dans ladite tranchée un espaceur métallique en un matériau différent de celui de la deuxième couche, en contact avec les flancs des troisième et deuxième couches ; et
d) prolonger ladite tranchée à travers au moins une partie de l'épaisseur de la première couche.

Selon l'invention, l'étape c) comprend :
- une étape de dépôt d'une couche métallique en ledit matériau différent de celui de la deuxième couche, sur la face supérieure de la troisième couche et sur les parois latérales et au fond de ladite tranchée ; puis
- une étape de gravure anisotrope verticale de la couche métallique, à l'issue de laquelle seules sont conservées les portions verticales de la couche métallique revêtant les parois latérales de ladite tranchée.

Selon un mode de réalisation, le procédé comprend en outre, après l'étape d), une étape de nettoyage chimique des surfaces exposées de la première couche à l'intérieur de la tranchée.

Selon un mode de réalisation, l'étape de nettoyage chimique est réalisée au moyen d'une solution à base d'hydroxyde de potassium ou d'une solution à base d'hydroxyde de tétraméthylammonium ou d'une solution à base d'hydroxyde de tétraéthylammonium.

Selon un mode de réalisation, la deuxième couche comprend de l'aluminium ou de l'argent.

Selon un mode de réalisation, les espaceurs sont en un métal du groupe comprenant le platine, le nickel et le tungstène.

Selon un mode de réalisation, la gravure mise en oeuvre à l'étape d) est une gravure sèche.

Selon un mode de réalisation, le procédé comprend en outre, entre l'étape a) et l'étape b), une étape de recuit de la deuxième couche à une température comprise entre 200°C et 900°C.

Selon un mode de réalisation, l'empilement comprend en outre, du côté de la première couche opposé à la deuxième couche, une troisième couche d'un composé III-N différent de celui de la première couche, et la gravure mise en oeuvre à l'étape d) traverse entièrement la première couche et au moins une partie de l'épaisseur de la troisième couche.

Selon un mode de réalisation, l'empilement comprend en outre, du côté de la troisième couche opposé à la première couche, une quatrième couche d'un composé III-N différent de celui de la troisième couche, et la gravure mise en oeuvre à l'étape d) traverse entièrement la troisième couche et au moins une partie de l'épaisseur de la quatrième couche.

### Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :
la figure 1 représente de façon schématique une étape d'un exemple d'un procédé de fabrication d'un composant semiconducteur selon un mode de réalisation ;
la figure 2 représente de façon schématique une autre étape d'un exemple d'un procédé de fabrication d'un composant semiconducteur selon un mode de réalisation ;
la figure 3 représente de façon schématique une autre étape d'un exemple d'un procédé de fabrication d'un composant semiconducteur selon un mode de réalisation ;
la figure 4 représente de façon schématique une autre étape d'un exemple d'un procédé de fabrication d'un composant semiconducteur selon un mode de réalisation ;
la figure 5 représente de façon schématique une autre étape d'un exemple d'un procédé de fabrication d'un composant semiconducteur selon un mode de réalisation ;
la figure 6 représente de façon schématique une autre étape d'un exemple d'un procédé de fabrication d'un composant semiconducteur selon un mode de réalisation ;
la figure 7 représente de façon schématique un exemple d'un composant semiconducteur réalisé par le procédé des figures 1 à 6 ; et
la figure 8 représente de façon schématique un autre exemple d'un composant semiconducteur réalisé par le procédé des figures 1 à 6.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, on s'intéresse ici plus particulièrement à la réalisation d'une métallisation de contact disposée sur et en contact avec une couche semiconductrice en un composé III-N dans un composant semiconducteur. Seules les étapes et éléments en lien avec la réalisation de cette métallisation ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures, étant entendu que, en pratique, les structures décrites peuvent être orientées différemment.

Sauf précision contraire, les expressions "environ", "approximativement", "sensiblement", et "de l'ordre de" signifient à 10 % près, de préférence à 5 % près.

Dans la présente description, on entend par composé III-N un matériau semiconducteur composite comprenant de l'azote (N), associé à un ou plusieurs éléments de la colonne III du tableau périodique des éléments, par exemple du gallium (Ga), de l'aluminium (Al) et/ou de l'indium (In). A titre d'exemple, on entend ici par composé III-N un matériau semiconducteur du groupe comprenant le nitrure de gallium (GaN), le nitrure d'indium-gallium (InGaN), le nitrure d'aluminium (AlN), le nitrure d'aluminium-gallium (AlGaN) et le nitrure d'indium-gallium-aluminium (InGaAlN).

De façon classique la fabrication d'un composant semiconducteur à base d'un composé III-N comprend la formation d'une métallisation de contact sur et en contact avec la face supérieure d'une couche du composé III-N, et la gravure, à partir de la face supérieure de la couche du composé III-N, d'une tranchée périphérique s'étendant verticalement à travers au moins une partie de l'épaisseur de la couche du composé III-N. On s'intéresse ici plus particulièrement aux étapes de réalisation de cette métallisation de contact et de cette tranchée périphérique.

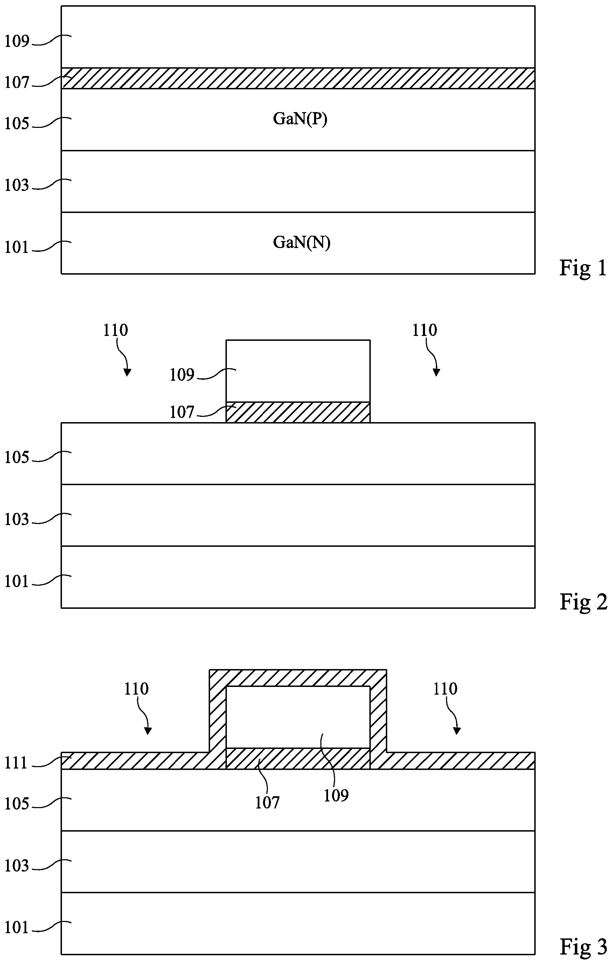

Les figures 1 à 6 sont des vues en coupe schématiques et partielles illustrant des étapes successives d'un procédé de fabrication d'un composant semiconducteur à base d'un composé III-N. A titre d'exemple illustratif, on considère ici la fabrication d'une diode électroluminescente (LED) au nitrure de gallium.

La figure 1 représente un empilement actif de LED comportant une couche 101 en nitrure de gallium (ou tout autre composé III-N à base de nitrure de gallium) dopé de type N, une couche émissive 103 revêtant la face supérieure de la couche 101, par exemple en contact avec la face supérieure de la couche 101, et une couche 105 en nitrure de gallium (ou tout autre composé III-N à base de nitrure de gallium) dopé de type P revêtant la face supérieure de la couche 103, par exemple en contact avec la face supérieure de la couche 103. La couche émissive 103 peut comprendre des moyens de confinement correspondant à des puits quantiques multiples. A titre d'exemple, la couche 103 comprend une alternance de couches semiconductrices d'un premier composé III-N et de couches semiconductrices d'un deuxième composé III-N, chaque couche du premier composé étant prise en sandwich entre deux couches du deuxième composé, le premier composé ayant une bande interdite plus étroite que celle du deuxième composé. Dans cet exemple, les couches 105 et 101 forment respectivement la région d'anode et la région de cathode de l'empilement de LED.

A ce stade du procédé, les couches 101, 103 et 105 s'étendent chacune de façon continue et sur une épaisseur sensiblement uniforme, sur toute la surface du composant.

L'empilement des couches 101, 103 et 105 peut reposer sur un substrat de support, non représenté, par exemple en saphir, disposé du côté de la face inférieure de la couche 101. Une couche tampon, non représentée, peut faire interface entre le substrat de support et la face inférieure de la couche 101. Les couches 101, 103 et 105 sont par exemple formées successivement par épitaxie à partir de la face supérieure du substrat de support ou de la couche tampon.

En pratique, une pluralité de LED peuvent être formées simultanément dans et sur l'empilement actif de LED formé par les couches 101, 103 et 105, par exemple en vue de former un micro-écran émissif à LED. Par souci de simplification, la réalisation d'une unique LED est représentée sur les figures 1 à 6.

La figure 1 illustre plus particulièrement une étape de formation d'une couche métallique 107 sur et en contact avec la face supérieure de la couche 105. La couche 107 comprend par exemple de l'aluminium ou de l'argent. Dans cet exemple, la couche 107 s'étend de façon continue et sur une épaisseur sensiblement uniforme sur toute la surface de la couche 105. Après le dépôt de la couche 107, pour améliorer la qualité du contact électrique entre la couche 107 et la couche 105, un recuit de la structure peut être prévu, par exemple à une température supérieure ou égale à 200°C et inférieure à la température de modification des couches épitaxiées sous-jacentes, par exemple de l'ordre de 900°C.

La figure 1 illustre en outre une étape de dépôt d'une couche de masque dur 109 sur la face supérieure de la couche métallique 107, par exemple en contact avec la face supérieure de la couche métallique 107, en vue d'étapes ultérieures de gravure localisée de la couche 107 et d'au moins une partie de l'épaisseur de l'empilement formé par les couches 101, 103 et 105. La couche de masque dur 109 est par exemple une couche d'oxyde de silicium d'épaisseur suffisamment importante pour protéger la couche métallique 107 sous-jacente lors des étapes ultérieures de gravure. La couche de masque dur 109 peut être déposée après le recuit éventuel de la couche métallique 107, de façon que le recuit de la couche 107 n'endommage pas la couche 109.

La figure 2 illustre une étape ultérieure (non détaillée) de lithographie et gravure de la couche de masque dur 109 et de la couche métallique 107, selon un motif de gravure fonction du composant que l'on cherche à réaliser. Dans cet exemple, lors de cette étape, la couche 109 est retirée dans une région périphérique de la LED, puis la couche métallique 107 est gravée dans ladite région périphérique de la LED, de façon à ne conserver qu'une portion de la couche métallique 107 dans une région centrale de la LED, ladite portion formant une métallisation de contact d'anode de la LED. Autrement dit, dans cet exemple, on forme à partir de la face supérieure de la couche 109 une tranchée périphérique 110 s'étendant verticalement à travers les couches 109 et 107, la tranchée 110 délimitant latéralement, dans la couche 107, la métallisation de contact d'anode de la LED. Dans l'exemple représenté, la gravure est interrompue sur la face supérieure de la couche de type P 105, c'est-à-dire lorsque la face supérieure de la couche 105 est dégagée des restes de la couche 107.

A l'issue de cette première gravure, la face supérieure de la métallisation de contact d'anode 107 reste protégée par la portion sus-jacente de la couche de masque dur 109. En revanche, les flancs de la métallisation de contact d'anode 107 sont exposés. Ainsi, un problème qui se pose est que la métallisation de contact d'anode 107 risque d'être endommagée lors d'une étape ultérieure de gravure, dans la région périphérique de la LED, d'au moins une partie de l'épaisseur de l'empilement formé par les couches 101, 103 et 105, et, plus spécifiquement, lors d'une étape de nettoyage/gravure chimique des parois de la région gravée de l'empilement des couches 101, 103 et 105.

La figure 3 illustre une étape de dépôt d'une couche métallique 111 sur la face supérieure de la structure obtenue à l'issue des étapes des figures 1 et 2. La couche 111 est en un métal différent de celui de la métallisation de contact d'anode 107 de la LED. Plus particulièrement, la couche 111 est en un métal présentant une vitesse d'attaque, par la solution chimique de nettoyage post gravure utilisée ultérieurement pour nettoyer les parois de la région gravée de l'empilement des couches 101, 103 et 105 dans la partie périphérique de la LED, inférieure à celle des matériaux semiconducteurs des couches 101, 103 et 105. De préférence, le métal de la couche 111 est choisi de façon à présenter une vitesse d'attaque par la solution chimique de nettoyage post gravure plus faible, par exemple au moins deux fois plus faible, que celle du métal de la métallisation 107. A titre d'exemple, la couche 111 est en un métal du groupe comprenant le platine, le nickel et le tungstène. De préférence, la couche 111 est en platine.

La couche métallique 111 est déposée de façon non localisée (pleine plaque), et s'étend ainsi de façon continue sur sensiblement toute la surface supérieure de la structure obtenue à l'issue des étapes des figures 1 et 2. En particulier, dans cet exemple, la couche 111 s'étend sur et en contact avec la face supérieure de la couche 105 dans la région périphérique de la LED (c'est-à-dire au fond de la tranchée périphérique 110), sur et en contact avec les flancs des portions centrales non gravées des couches 107 et 109 (c'est-à-dire sur les parois latérales de la tranchée 110), et sur et en contact avec la face supérieure de la couche 109 dans la partie centrale de la LED (en dehors de la tranchée périphérique 110). La couche 111 peut être déposée par une méthode de dépôt conforme de façon à présenter une épaisseur sensiblement uniforme sur toute la surface de la structure. A titre d'exemple, la couche 111 est déposée par dépôt physique en phase vapeur (PVD), par exemple au moyen d'un plasma RF-DC, ou par dépôt chimique en phase vapeur (CVD). L'épaisseur de la couche 111 est par exemple comprise entre 10 nm et 1 µm.

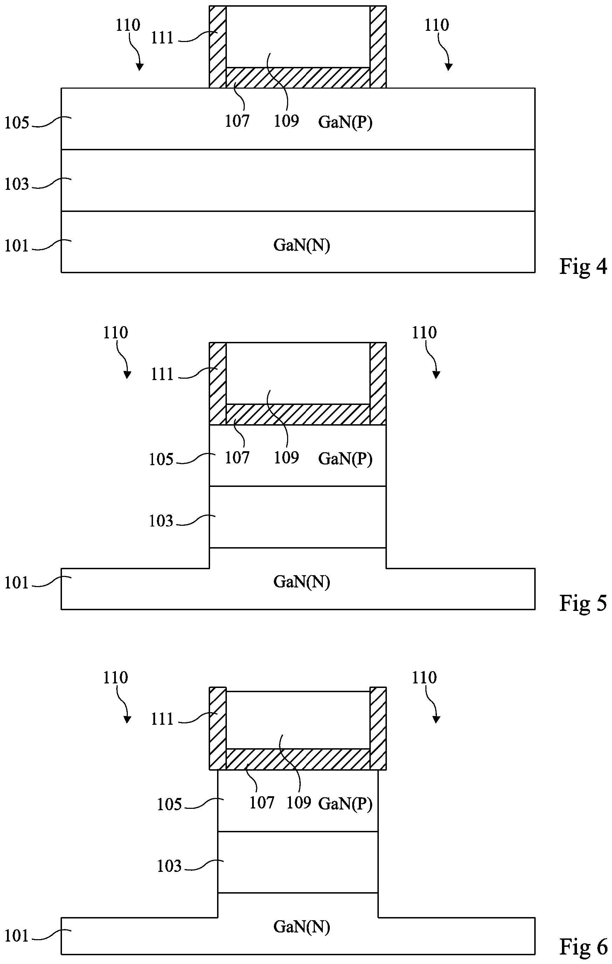

La figure 4 illustre une étape ultérieure de gravure directionnelle (ou anisotrope) verticale non localisée (pleine plaque) de la couche métallique 111, de façon à retirer les portions horizontales et conserver uniquement les portions verticales de la couche 111. La gravure mise en oeuvre lors de cette étape est par exemple une gravure de type IBE (de l'anglais "Ion Beam Etching" - gravure par faisceau d'ions) ou par gravure de type RIE (de l'anglais "Reactive Ion Etch" - gravure par ions réactifs) ou encore par gravure de type HD-RIE (de l'anglais "High-Density plasma Reactive Ion Etch" - gravure par ions réactifs à plasma haute densité, par exemple à base de plasmas ICP, microonde, ou couplage capacitif).

A l'issue de cette étape, seules les portions verticales de la couche 111 revêtant les flancs de la métallisation de contact d'anode 107 et de la portion sus-jacente de masque dur 109 (c'est-à-dire les parois latérales de la tranchée 110) sont conservées, formant des espaceurs métalliques protégeant les flancs de la métallisation de contact d'anode 107.

La figure 5 illustre une étape ultérieure de gravure d'au moins une partie de l'épaisseur de l'empilement formé par les couches 101, 103 et 105 dans la région périphérique de la LED, à partir de la face supérieure de l'empilement. Autrement dit, lors de cette étape, la tranchée périphérique 110 est prolongée verticalement à travers au moins une partie de l'épaisseur de l'empilement formé par les couches 101, 103 et 105. Dans cet exemple, la gravure traverse entièrement la couche d'anode 105 et la couche émissive 103, et est interrompue à un niveau intermédiaire de la couche de cathode 101. La gravure mise en oeuvre lors de cette étape est une gravure sèche, par exemple une gravure plasma. Le masque dur 109 permet de protéger la partie centrale de la LED lors de la gravure.

La figure 6 illustre une étape ultérieure de nettoyage, par gravure chimique humide, des surfaces exposées des couches semiconductrices 105, 103 et 101 à l'intérieur de la tranchée 110. Cette étape de nettoyage chimique a pour but de retirer les éventuelles portions semiconductrices endommagées par la gravure sèche au niveau des parois latérales et du fond de la tranchée 110, qui risqueraient de causer des disfonctionnements de la LED.

La solution chimique utilisée à cette étape peut être une solution à base d'hydroxyde de potassium (KOH), ou une solution à base d'hydroxyde de tétraméthylammonium (TMAH), ou une solution à base d'hydroxyde de tétraéthylammonium (TEAH), ou toute autre solution adaptée à graver de manière contrôlée les surfaces exposées des couches 101, 103 et 105.

Comme l'illustre la figure 6, le nettoyage chimique conduit à un léger retrait des matériaux des couches 101, 103 et 105 au niveau des parois latérales et du fond de la tranchée 110, de préférence sur une épaisseur inférieure à celle des espaceurs métalliques 111, par exemple sur une épaisseur comprise entre 5 et 300 nm. Lors de cette étape, la métallisation de contact d'anode 107 est protégée latéralement de la solution de gravure chimique par les espaceurs métalliques 111.

Les étapes suivantes (non détaillées) du procédé peuvent correspondre à des étapes usuelles de fabrication d'une LED au nitrure de gallium.

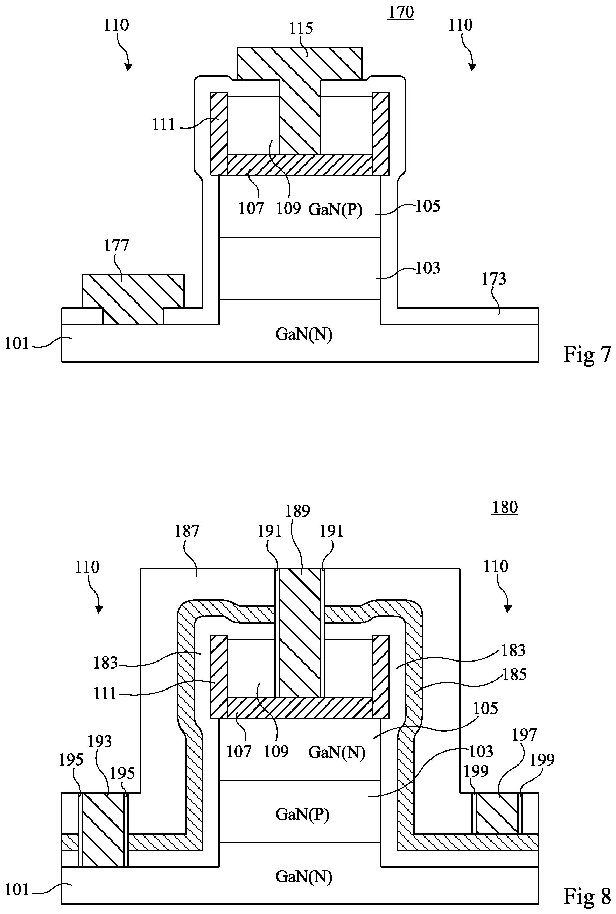

La figure 7 est une vue en coupe schématique et partielle illustrant un exemple de LED au nitrure de gallium 170 pouvant être obtenue par un tel procédé.

Dans cet exemple, la LED 170 comprend une couche de passivation 173, par exemple en oxyde de silicium, revêtant sensiblement toute la surface de la structure obtenue à l'issue des étapes des figures 1 à 6. Plus particulièrement, dans cet exemple, la couche de passivation 173 recouvre la face supérieure de la couche 101 au fond des tranchées 110, les flancs des couches semiconductrices 101, 103 et 105 et des espaceurs métalliques 111 au niveau des parois latérales des tranchées 110, et la face supérieure des espaceurs 111 et de la couche 109 au niveau de la partie centrale de la LED. La couche 173 est par exemple déposée sur toute la surface supérieure de la structure obtenue à l'issue des étapes des figures 1 à 6, par une méthode de dépôt non localisé (pleine plaque).

La LED 170 comprend en outre, au niveau de sa partie centrale, une métallisation de connexion d'anode 175 s'étendant dans une ouverture formée dans les couches isolantes 173 et 109, la métallisation 175 étant en contact, par sa face inférieure, avec la face supérieure de la métallisation 107. La LED 170 comprend de plus, au niveau de sa partie périphérique, une métallisation de connexion de cathode 177 s'étendant dans une ouverture formée dans la couche isolante 173, la métallisation 177 étant en contact, par sa face inférieure, avec la face supérieure de la région semiconductrice de cathode 101 restant après gravure.

Un avantage du procédé décrit en relation avec les figures 1 à 6 est que les espaceurs métalliques 111 protègent la métallisation de contact d'anode 107 lors de l'étape de nettoyage chimique des parties exposés des couches semiconductrices 101, 103 et 105 à l'issue de l'étape de gravure des couches 101, 103 et 105. Ainsi, la métallisation 107 peut être formée dès le début du procédé, ce qui permet notamment de soumettre la métallisation 107 à un recuit permettant d'améliorer la qualité du contact électrique avec la couche 105. On notera en effet que si la métallisation 107 était formée à la fin du procédé, un recuit à haute température de la couche métallique 107 risquerait d'endommager la LED. En outre, le métal de la couche 107 peut être choisi sans précaution particulière quant à ses propriétés d'inertie chimique, mais plutôt en favorisant ses propriétés de contact à faible résistivité et/ou ses propriétés de réflectivité.

Les modes de réalisation décrits ne se limitent pas à l'exemple particulier décrit ci-dessus dans lequel le masque dur 109 est en oxyde de silicium. A titre de variante, le masque 109 peut être en métal, par exemple en le même métal que les espaceurs 111, par exemple en platine ou en nickel.

Plus généralement, ce procédé peut être adapté à la fabrication de tout composant semiconducteur à base d'un composé III-N, comprenant une métallisation de contact sur la face supérieure d'une couche d'un composé III-N et nécessitant une gravure d'une tranchée périphérique s'étendant sur au moins une partie de l'épaisseur de la couche du composé III-N.

La figure 8 est une vue en coupe schématique et partielle illustrant un exemple d'un transistor MOS vertical au nitrure de gallium 180 pouvant être obtenu par un tel procédé. Dans cet exemple, la couche 101 est une couche de nitrure de gallium (ou tout autre composé III-N à base de nitrure de gallium) dopé de type N, la couche 105 est une couche de nitrure de gallium (ou tout autre composé III-N à base de nitrure de gallium) dopé de type N, par exemple sensiblement de même niveau de dopage que la couche 101, et la couche 103 est une couche de nitrure de gallium (ou tout autre composé III-N à base de nitrure de gallium) dopé de type P ou une couche de nitrure de gallium (ou tout autre composé III-N à base de nitrure de gallium) dopé de type N de niveau de dopage inférieur à celui des couches 101 et 105.

Dans cet exemple, le transistor 180 comprend une couche d'isolant de grille 183, par exemple en oxyde de silicium, revêtant sensiblement toute la surface de la structure obtenue à l'issue des étapes des figures 1 à 6. Plus particulièrement, dans cet exemple, la couche d'isolant de grille 183 recouvre la face supérieure de la couche 101 au fond des tranchées 110, les flancs des couches semiconductrices 101, 103 et 105 et des espaceurs métalliques 111 au niveau des parois latérales des tranchées 110, et la face supérieure des espaceurs 111 et de la couche 109 au niveau de la partie centrale du composant. La couche d'isolant de grille 183 est notamment en contact avec les flancs de la portion non gravée de la couche semiconductrice 103, qui constitue la région de formation de canal du transistor.

Le transistor 180 comprend en outre une couche conductrice de grille 185, par exemple une couche métallique, revêtant sensiblement toute la surface supérieure de la couche d'isolant de grille 183.

Les couches 183 et 185 sont par exemple déposées successivement sur toute la surface de la structure, par une méthode de dépôt conforme non localisé, à l'issue des étapes des figures 1 à 6. A titre d'exemple, les couches 183 et 185 sont déposées par une méthode de dépôt en couches monoatomiques successives aussi appelée ALD (de l'anglais "Atomic Layer Déposition"), ou par dépôt PECVD (de l'anglais "Plasma Enhanced Chemical Vapor Déposition" - dépôt chimique en phase vapeur assisté par plasma).

Le transistor 180 comprend en outre une couche de passivation 187, par exemple en oxyde de silicium, revêtant sensiblement toute la surface de la structure obtenue après dépôt des couches 183 et 185. La couche 187 est par exemple déposée par une méthode de dépôt non localisé (pleine plaque) .

Le transistor 180 comprend en outre, au niveau de sa partie centrale, une métallisation de connexion 189 s'étendant dans une ouverture formée dans les couches 187, 185, 183 et 109, la métallisation 189 étant en contact, par sa face inférieure, avec la face supérieure de la métallisation 107. La métallisation de connexion 189 est isolée latéralement de la couche conductrice de grille 185 par des espaceurs 191 en un matériau isolant, par exemple en oxyde de silicium.

Le transistor 180 comprend en outre, au niveau de sa région périphérique, une métallisation de connexion 193 s'étendant dans une ouverture formée dans les couches 187, 185 et 183, la métallisation 193 étant en contact, par sa face inférieure, avec la face supérieure de la couche semiconductrice 101. La métallisation de connexion 193 est isolée latéralement de la couche conductrice de grille 185 par des espaceurs 195 en un matériau isolant, par exemple de l'oxyde de silicium.

Le transistor 180 comprend en outre, au niveau de sa région périphérique, une métallisation de connexion 197 s'étendant dans une ouverture formée dans la couche 187, la métallisation 197 étant en contact, par sa face inférieure, avec la face supérieure de la couche conductrice de grille 185 du transistor. Dans l'exemple représenté, la métallisation de connexion 197 est séparée latéralement de la couche de passivation 187 par des espaceurs 199 en un matériau isolant, par exemple de l'oxyde de silicium. Ceci résulte du fait que, dans cet exemple, les étapes de formation des ouvertures, de formation des espaceurs, et de remplissage des ouvertures par du métal, sont mises en oeuvre simultanément pour chacune des trois métallisations 189, 193 et 197. A titre de variante, les espaceurs 199 peuvent être omis.

Dans cet exemple, les métallisations 189, 193 et 197 constituent respectivement des première et deuxième bornes de conduction et une borne de commande du transistor 180.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, les modes de réalisation décrits ne se limitent pas aux exemples de composants semiconducteurs décrits ci-dessus, mais s'appliquent plus généralement à la fabrication de tout composant semiconducteur comportant une portion de couche d'un composé III-N revêtue d'une métallisation de contact et délimitée latéralement par une tranchée gravée dans ladite couche. A titre d'exemple, le procédé décrit ci-dessus peut s'appliquer à la fabrication de diodes photosensibles ou de diodes de puissance à base de composés III-N.

## Revendications

1. Procédé de fabrication d'un composant semiconducteur (170, 180), comprenant les étapes successives suivantes :
a) former un empilement comportant une première couche semiconductrice (105) en un composé III-N, une deuxième couche conductrice (107) revêtant la première couche, et une troisième couche de masque dur (109) revêtant la deuxième couche (107) ;
b) former une tranchée (110) traversant les troisième (109) et deuxième (107) couches et s'interrompant sur la première couche (105), ladite tranchée délimitant latéralement une métallisation de contact dans la deuxième couche (107) ;
c) former dans ladite tranchée (110) un espaceur métallique (111) en un matériau différent de celui de la deuxième couche (107), en contact avec les flancs des troisième (109) et deuxième (107) couches ; et
d) prolonger ladite tranchée (110) à travers au moins une partie de l'épaisseur de la première couche (105), **caractérisé en ce que** l'étape c) comprend :
- une étape de dépôt d'une couche métallique (111) en ledit matériau différent de celui de la deuxième couche (107), sur la face supérieure de la troisième couche (109) et sur les parois latérales et au fond de ladite tranchée (110) ; puis
- une étape de gravure anisotrope verticale de la couche métallique (111), à l'issue de laquelle seules sont conservées les portions verticales de la couche métallique (111) revêtant les parois latérales de ladite tranchée (110) .

2. Procédé selon la revendication 1, comprenant en outre, après l'étape d), une étape de nettoyage chimique des surfaces exposées de la première couche (105) à l'intérieur de la tranchée (110).

3. Procédé selon la revendication 2, dans lequel l'étape de nettoyage chimique est réalisée au moyen d'une solution à base d'hydroxyde de potassium (KOH) ou d'une solution à base d'hydroxyde de tétraméthylammonium (TMAH) ou d'une solution à base d'hydroxyde de tétraéthylammonium (TEAH).

4. Procédé selon l'une quelconque des revendications 1 à 3, dans lequel la deuxième couche (107) comprend de l'aluminium ou de l'argent.

5. Procédé selon l'une quelconque des revendications 1 à 4, dans lequel les espaceurs (111) sont en un métal du groupe comprenant le platine, le nickel et le tungstène.

6. Procédé selon l'une quelconque des revendications 1 à 5, dans lequel la gravure mise en oeuvre à l'étape d) est une gravure sèche.

7. Procédé selon l'une quelconque des revendications 1 à 6, comprenant en outre, entre l'étape a) et l'étape b), une étape de recuit de la deuxième couche (107) à une température comprise entre 200°C et 900°C.

8. Procédé selon l'une quelconque des revendications 1 à 7, dans lequel l'empilement comprend en outre, du côté de la première couche (105) opposé à la deuxième couche (107), une troisième couche (103) d'un composé III-N différent de celui de la première couche, et dans lequel la gravure mise en oeuvre à l'étape d) traverse entièrement la première couche (105) et au moins une partie de l'épaisseur de la troisième couche (103).

9. Procédé selon la revendication 8, dans lequel l'empilement comprend en outre, du côté de la troisième couche (103) opposé à la première couche (105), une quatrième couche (101) d'un composé III-N différent de celui de la troisième couche, et dans lequel la gravure mise en oeuvre à l'étape d) traverse entièrement la troisième couche (103) et au moins une partie de l'épaisseur de la quatrième couche (101).

## Patentansprüche

1. Verfahren zur Herstellung eines Halbleiterbauelements (170, 180), das die folgenden aufeinanderfolgenden Schritte aufweist:
a) Bilden eines Stapels, der eine erste Halbleiterschicht (105) aus einer III-N-Verbindung, eine zweite leitende Schicht (107), die die erste Schicht bedeckt, und eine dritte Hartmaskenschicht (109), die die zweite Schicht (107) bedeckt, aufweist;
b) Ausbilden eines Grabens (110), der die dritte (109) und die zweite (107) Schicht durchquert und auf der ersten Schicht (105) endet, wobei der Graben eine Kontaktmetallisierung in der zweiten Schicht (107) seitlich begrenzt;
c) Ausbilden eines Metall-Abstandshalters (111) in dem Graben (110), der aus einem Material besteht, das sich von dem der zweiten Schicht (107) unterscheidet, und der mit den Seiten der dritten (109) und der zweiten (107) Schicht in Kontakt steht; und
d) Fortsetzen des Grabens (110) durch mindestens einen Teil der Dicke der ersten Schicht (105),
**dadurch gekennzeichnet, dass** der Schritt c) Folgendes aufweist:
- einen Schritt des Aufbringens einer Metallschicht (111) aus dem Material, das sich von dem der zweiten Schicht (107) unterscheidet, auf der oberen Oberfläche der dritten Schicht (109) und auf den Seitenwänden und am Boden des Grabens (110); dann
- einen Schritt des vertikalen anisotropen Ätzens der Metallschicht (111), an dessen Ende nur die vertikalen Abschnitte der Metallschicht (111), die die Seitenwände des Grabens (110) bedecken, erhalten bleiben.

2. Verfahren nach Anspruch 1, das nach Schritt d) ferner einen Schritt des chemischen Reinigens der freiliegenden Oberflächen der ersten Schicht (105) im Inneren des Grabens (110) aufweist.

3. Verfahren nach Anspruch 2, wobei der Schritt der chemischen Reinigung mittels einer Lösung auf der Basis von Kaliumhydroxid (KOH) oder einer Lösung auf der Basis von Tetramethylammoniumhydroxid (TMAH) oder einer Lösung auf der Basis von Tetraethylammoniumhydroxid (TEAH) durchgeführt wird.

4. Verfahren nach einem der Ansprüche 1 bis 3, wobei die zweite Schicht (107) Aluminium oder Silber aufweist.

5. Verfahren nach einem der Ansprüche 1 bis 4, wobei die Abstandshalter (111) aus einem Metall aus der Gruppe Platin, Nickel und Wolfram hergestellt sind.

6. Verfahren nach einem der Ansprüche 1 bis 5, wobei das in Schritt d) durchgeführte Ätzen ein Trockenätzen ist.

7. Verfahren nach einem der Ansprüche 1 bis 6, das zwischen Schritt a) und Schritt b) ferner einen Schritt des Temperns der zweiten Schicht (107) bei einer Temperatur im Bereich von 200 °C bis 900 °C aufweist.

8. Verfahren nach einem der Ansprüche 1 bis 7, wobei der Stapel ferner auf der Seite der ersten Schicht (105), die der zweiten Schicht (107) gegenüberliegt, eine dritte Schicht (103) aus einer III-N-Verbindung aufweist, die sich von der der ersten Schicht unterscheidet, und wobei das in Schritt d) durchgeführte Ätzen die erste Schicht (105) vollständig und mindestens einen Teil der Dicke der dritten Schicht (103) durchquert.

9. Verfahren nach Anspruch 8, wobei der Stapel ferner auf der Seite der dritten Schicht (103), die der ersten Schicht (105) gegenüberliegt, eine vierte Schicht (101) aus einer III-N-Verbindung aufweist, die sich von derjenigen der dritten Schicht unterscheidet, und wobei das in Schritt d) durchgeführte Ätzen die dritte Schicht (103) vollständig und mindestens einen Teil der Dicke der vierten Schicht (101) durchquert.

## Claims

1. Method of manufacturing a semiconductor component (170, 180), comprising the successive steps of:
a) forming a stack comprising a first semiconductor layer (105) made of a III-N compound, a second conductive layer (107) coating the first layer, and a third hard mask layer (109) coating the second layer (107);
b) forming a trench (110) crossing the third (109) and second (107) layers and stopping on the first layer (105), said trench laterally delimiting a contact metallization in the second layer (107);
c) forming in said trench (110) a metal spacer (111) made of a material different from that of the second layer (107), in contact with the sides of the third (109) and second (107) layers; and
d) continuing said trench (110) through at least a portion of the thickness of the first layer (105), **characterized in that** step c) comprises:
- a step of deposition of a metal layer (111) made of said material different from that of the second layer (107), on the upper surface of the third layer (109) and on the lateral walls and at the bottom of said trench (110); then
- a step of vertical anisotropic etching of the metal layer (111), at the end of which only the vertical portions of the metal layer (111) coating the lateral walls of said trench (110) are kept.

2. Method according to claim 1, further comprising, after step d), a step of chemical cleaning of the exposed surfaces of the first layer (105) inside of the trench (110) .

3. Method according to claim 2, wherein the step of chemical cleaning is carried out by means of a solution based on potassium hydroxide (KOH) or of a solution based on tetramethylammonium hydroxide (TMAH), or of a solution based on tetraethylammonium hydroxide (TEAH).

4. Method according to any of claims 1 to 3, wherein the second layer (107) comprises aluminum or silver.

5. Method according to any of claims 1 to 4, wherein the spacers (111) are made of a metal from the group comprising platinum, nickel, and tungsten.

6. Method according to any of claims 1 to 5, wherein the etching implemented at step d) is a dry etching.

7. Method according to any of claims 1 to 6, further comprising, between step a) and step b), a step of anneal of the second layer (107) at a temperature in the range from 200°C to 900°C.

8. Method according to any of claims 1 to 7, wherein the stack further comprises, on the side of the first layer (105) opposite to the second layer (107), a third layer (103) of a III-N compound different from that of the first layer, and wherein the etching implemented at step d) thoroughly crosses the first layer (105) and at least a portion of the thickness of the third layer (103).

9. Method according to claim 8, wherein the stack further comprises, on the side of the third layer (103) opposite to the first layer (105), a fourth layer (101) of a III-N compound different from that of the third layer, and wherein the etching implemented at step d) thoroughly crosses the third layer (103) and at least a portion of the thickness of the fourth layer (101).
